# FASCICULE DE BREVET EUROPEEN

(11) **EP 2 391 578 B1**
(45) Date de publication et mention de la délivrance du brevet: **02.01.2013**
(21) Numéro de dépôt: 10701373.2
(22) Date de dépôt: 28.01.2010
(51) Int. Cl.: B82B 3/00, H01L 21/00, C30B 11/12, C30B 29/60

(54) **PROCEDE DE FORMATION DE NANO-FILS ET PROCEDE DE FABRICATION DE COMPOSANT OPTIQUE ASSOCIE**
VERFAHREN ZUR BILDUNG VON NANODRÄHTEN UND ZUGEHÖRIGES VERFAHREN ZUR HERSTELLUNG EINER OPTISCHEN KOMPONENTE
METHOD FOR FORMING NANOWIRES AND ASSOCIATED METHOD FOR MANUFACTURING AN OPTICAL COMPONENT

(30) Priorité: 30.01.2009 FR 0950573
(43) Date de publication de la demande: 07.12.2011
(73) Titulaire: Commissariat à l'Énergie Atomique et aux Énergies Alternatives, 75015 Paris (FR)
(72) Inventeur: NEEL, Delphine, F-69200 Vénissieux (FR); FERRET, Pierre, F-38000 Grenoble (FR); GETIN, Stéphane, F-38100 Grenoble (FR)
(74) Mandataire: Ilgart, Jean-Christophe
(86) Numéro de dépôt international: PCT/EP2010/051012
(87) Numéro de publication internationale: WO 2010/086378

(56) Documents cités:
- WO-A-2004/004927
- GB-A- 2 436 449
- US-A1- 2005 122 550
- US-A1- 2005 151 126
- DIENEROWITTZ ET AL: "Optical manipulation of nanoparticles: a review" JORNAL OF NANOPHOTONICS, vol. 2, 10 août 2008 (2008-08-10), pages 1-31, XP040447263
- CUI ET AL.: "Diameter controlled synthesis of single crystal silicon nanowires" APPLIED PHYSICS LETTERS, vol. 78, no. 15, 9 avril 2001 (2001-04-09) , pages 2214-2216, XP002535075

## Description

### Domaine technique et art antérieur

L'invention concerne un procédé de formation de nano-fil à la surface d'un substrat et, plus particulièrement, un procédé de formation de nano-fil à la surface d'un substrat fixé sur la face plane d'une lentille solide à immersion.

L'invention concerne également un procédé de fabrication de composant optique qui comprend une étape de formation de nano-fil conforme au procédé de formation de nano-fil de l'invention.

L'invention s'applique aux technologies de fabrication de nano-fils telles que, par exemple, la technologie d'approche ascendante plus communément connue sous l'appellation anglo-saxonne de technologie « bottom up ». Les domaines concernés par l'invention sont ceux de la microélectronique, de l'éclairage, du photovoltaïque, etc..

Il existe différentes méthodes de croissance de nano-fils. Parmi les plus connues, figure la méthode VLS (VLS pour « Vapor-Liquid-Solid » ou « Vapeur-Liquide-Solide ») qui utilise un catalyseur métallique. Le métal le plus couramment utilisé comme catalyseur est l'or, en raison de la faible température d'eutectique du mélange or-silicium qui n'est que de 363°C. L'or permet donc une croissance à relativement basse température. On peut aussi utiliser, entre autres, le nickel, le cuivre, le platine, l'argent ou le palladium. Cependant ces métaux nécessitent de travailler à des températures beaucoup plus hautes. Il est également possible d'utiliser le nickel, le titane ou l'aluminium.

La méthode VLS utilise des îlots métalliques, généralement de l'or, comme catalyseurs à la croissance des nano-fils. Les îlots sont obtenus par dépôt de colloïdes métalliques sur un substrat ou par démouillage d'une couche mince métallique.

Les colloïdes d'or (particules de diamètre inférieur à 100nm) sont déposés à la surface d'un wafer de semi-conducteur. Les substrats sont placés dans un bâti où les colloïdes sont chauffés jusqu'à leur point de fusion. Des gaz précurseurs sont introduits dans le bâti, causant une saturation en semi-conducteur dans la goutte métallique. La croissance cristalline se produit à l'interface liquide-solide par précipitation. Le diamètre des nano-fils est déterminé par la taille de la goutte d'alliage métal-semi-conducteur, elle-même déterminée par la taille originelle des colloïdes d'or. L'utilisation de colloïdes d'or permet un meilleur contrôle du diamètre des fils que l'utilisation d'une couche mince métallique.

Le démouillage d'une couche métallique mince consiste en l'évaporation d'un film métallique mince ayant une épaisseur de quelques nanomètres, suivie d'un recuit afin de former des îlots métalliques de taille nanométrique. Une fois les îlots formés, le mécanisme de croissance est le même que pour les colloïdes. Avec cette technique, la dispersion en taille des gouttes est importante ce qui influe sur le diamètre des fils après croissance. De plus, la position des gouttes est aléatoire.

Certains nano-fils, comme les nano-fils en ZnO ou Ga₂O₃, peuvent croître sans catalyseur métallique. La méthode de croissance est alors la méthode VS (VS pour « Vapor-Solid » ou « Vapeur-Solide »). Par exemple, pour le ZnO, la croissance des nano-fils est obtenue par évaporation thermique d'une poudre métallique de ZnO.

Certaines méthodes de croissance de nano-fils s'accompagnent d'une localisation précise de ceux-ci. Selon une première de ces méthodes, on insole par photolithographie ou par lithographie par faisceau d'électrons (communément appelée lithographie e-beam) une couche de résine déposée sur un substrat semi-conducteur. On dépose ensuite une couche mince d'or sur l'échantillon, puis la résine est retirée. Il en résulte un motif constitué d'un réseau de plots d'or. La croissance des fils est ensuite réalisée classiquement par méthode VLS mentionnée ci-dessus. Les fils produits ainsi sont parfaitement perpendiculaires au substrat et présentent une grande régularité en taille, diamètre, localisation et uniformité. Les zones insolées peuvent aller jusqu'à plusieurs centimètres carrés. La précision de positionnement est d'environ 8 à 10nm pour la lithographie par faisceau d'électrons et dépend de la longueur d'onde utilisée pour la lithographie optique. Les avantages d'une telle méthode sont d'obtenir une bonne précision de positionnement des nano-fils et de permettre la réalisation de tout type de motif. Les inconvénients sont toutefois nombreux, à savoir le coût et la complexité de l'équipement nécessaire à la réalisation de la méthode (par exemple, le coût des masques pour la lithographie optique).

Selon une deuxième méthode, une couche de résine est déposée sur un substrat de silicium. Un motif constitué d'un réseau de trous est insolé dans la résine par lithographie par faisceau d'électrons. Le silicium est gravé, au niveau des trous dans la résine, par gravure ionique réactive. Une couche métallique est ensuite déposée sur l'échantillon par évaporation. La couche métallique se dépose donc par-dessus la résine et au fond du trou. La couche métallique située au-dessus de la résine est alors enlevée. Enfin, la croissance des nano-fils est réalisée par une méthode VLS classique telle que mentionnée précédemment, l'îlot métallique situé au fond du trou servant de catalyseur. Les fils produits grâce à cette méthode sont homogènes en diamètre et en longueur mais présentent quelques défauts cristallographiques. L'avantage de cet autre méthode réside également dans la bonne précision qui est obtenue pour localiser les nano-fils. Le coût et la complexité de l'équipement sont toutefois de réels inconvénients, de même que la situation occupée par les nano-fils, lesquels sont situés dans des trous.

Selon une troisième méthode, une monocouche de billes de polystyrène est déposée sur un substrat de silicium et s'auto-organise en un motif régulier. Une gravure RIE (RIE pour « Réactive Ion Etching », c'est-à-dire une gravure plasma) permet de réduire la taille des billes jusqu'à une taille colloïdale. Une couche d'argent est déposée sur l'ensemble formé par les billes et le substrat. Une attaque dans de l'acide fluorhydrique et du H₂O₂ permet de graver le silicium sous la couche d'argent. L'argent est ensuite enlevé par une attaque dans de l'eau régale et les billes sont ôtées par une attaque dans de l'acide chlorhydrique. On obtient ainsi un ensemble de fils répartis selon un motif organisé. L'avantage de cette troisième méthode est d'obtenir une bonne régularité du motif, l'inconvénient résidant dans l'impossibilité qu'il y a à réaliser des motifs aléatoires.

Une quatrième méthode consiste à utiliser des pointes AFM (AFM pour « Atomic Force Microscopy ») ou pointes de microscope à force atomique pour la réalisation des nano-fils. Des colloïdes d'or sont tout d'abord déposés sur un substrat de silicium à l'aide d'un aérosol. Une pointe AFM en mode contact est alors utilisée pour pousser les colloïdes et les déplacer aux endroits voulus. La croissance des nano-fils est ensuite réalisée par des méthodes classiques. Les avantages de cette méthode sont une très grande précision de la localisation (de l'ordre du nanomètre) et le fait que n'importe quel motif est réalisable. Les inconvénients sont la lenteur de déplacement de la pointe AFM, le fait qu'un seul colloïde est manipulé à la fois et le fait que la méthode n'est pas utilisable si la surface du substrat silicium présente d'importants changements de topographie.

Une cinquième méthode utilise des nano-pores. Les nano-pores sont formés par anodisation d'une membrane d'aluminium. Les nano-pores obtenus sont auto-organisés selon un réseau de diamètre et de profondeur uniformes. La membrane est déposée sur un substrat semi-conducteur. Une couche métallique est déposée par évaporation sur le substrat. Le métal à la surface est enlevé. Un réseau de plots métalliques subsiste donc au fond des nano-pores. La croissance des nano-fils a alors lieu par méthode VLS. Un avantage est la régularité du motif. Les inconvénients sont que les motifs aléatoires ne sont pas réalisables et que les nano-fils sont dans des trous.

Une sixième méthode concerne la lithographie par nano-impression. On applique un moule en polydiméthylsiloxane (ou PDMS) recouvert d'une "encre" en poly-L-lysine à la surface d'un substrat de silicium. Au niveau des zones de contact, la poly-L-lysine se retrouve transférée sur le silicium. Le substrat est alors immergé dans une solution contenant des colloïdes d'or. Les colloïdes se fixent uniquement sur les zones recouvertes de poly-L-lysine et pas sur le substrat nu. La croissance des fils est ensuite réalisée par la méthode VLS. Un inconvénient majeur d'une telle méthode est le coût du moule.

La fabrication de composants optiques comprenant une lentille solide à immersion couplée à un nano-fil est également connue de l'art antérieur.

On réalise tout d'abord la lentille solide à immersion. Sur la partie plane de la lentille, on dépose ensuite une bicouche de matériau semi-conducteur (par exemple Si ou ZnO) et de précurseur (par exemple Au). On grave la bicouche de telle sorte que celle-ci ne reste qu'au centre de la lentille. La largeur de la gravure est comprise entre la dizaine et la centaine de nanomètres. Par l'une quelconque des techniques mentionnées ci-dessus, on forme alors un élément catalyseur en surface de la bicouche gravée et on fait croître un nano-fil à partir de l'élément catalyseur. Ce procédé de fabrication de composant optique présente une difficulté majeure, à savoir le centrage de la bicouche gravée sur la lentille. Il suffit d'un décentrage de l'ordre de grandeur du diamètre du nano-fil (par exemple, quelques dizaines à quelques centaines de nanomètres) pour que, le composant optique une fois terminé, il ne soit plus possible de coupler dans le nano-fil la lumière injectée dans la lentille.

Le procédé de l'invention ne présente pas les inconvénients des procédés de l'art antérieur mentionnés ci-dessus.

La demande de brevet WO 2004/004927 A divulgue un procédé de formation de nano-fils à la surface d'un substrat. Le procédé comporte une étape de formation d'éléments catalyseurs à la surface du substrat.

La demande de brevet US 2005/122550 A1 divulgue la manipulation de nano-particules à l'aide d'une pince optique.

Le document Dienerowittz et al. : « Optical manipulation of nanoparticles : a review » Journal of Nanophotonics, vol.2, 10 août 2008, pages 1-31, XP 040447263 divulgue la possibilité d'employer une lentille solide à immersion lors de manipulation par pince optique.

### Exposé de l'invention

En effet, l'invention concerne un procédé de formation de nano-fil à la surface d'un substrat fixé sur une face plane d'une lentille solide à immersion, le procédé comprenant une étape de formation d'au moins un élément catalyseur à la surface du substrat et une étape de croissance de nano-fil à partir de chaque élément catalyseur formé à la surface du substrat. L'élément catalyseur étant une nano-particule métallique et le substrat étant transparent à une longueur d'onde de travail, l'étape de formation d'un élément catalyseur à la surface du substrat comprend les étapes successives suivantes .
- mise en contact du substrat avec un fluide placé dans une cuve qui contient des nano-particules métalliques,
- focalisation d'un faisceau lumineux à la longueur d'onde de travail au niveau du substrat, à l'aide d'un faisceau lumineux incident sur une face hémisphérique de la lentille solide à immersion,
- déplacement de la cuve jusqu'à temps qu'une nano-particule métallique soit piégée dans le faisceau lumineux focalisé, et
- fixation de la nano-particule métallique piégée sur le substrat.

Selon une caractéristique supplémentaire de l'invention, le fluide étant un liquide qui emplit la cuve, dès lors que la nano-particule métallique est fixée sur le substrat, la cuve est démontée et une étape de séchage sèche le substrat.

Selon une autre caractéristique supplémentaire de l'invention, le fluide étant de l'air qui emplit la cuve, les nano-particules sont introduites dans la cuve à l'aide d'un nébuliseur et, dès lors que la nano-particule est fixée sur le substrat, la cuve est démontée.

Selon encore une autre caractéristique supplémentaire de l'invention, la nano-particule métallique est fixée par fusion à la surface du substrat.

Selon encore une autre caractéristique supplémentaire de l'invention, le substrat est préalablement recouvert d'un traitement de surface apte à faciliter la fixation de la nano-particule sur le substrat.

Selon encore une autre caractéristique supplémentaire de l'invention, le traitement de surface est un traitement à la poly-L-lysine ou un traitement par aminosilane.

Selon encore une autre caractéristique supplémentaire de l'invention, le traitement de surface est retiré avant l'étape de croissance des nano-fils.

Selon encore une autre caractéristique supplémentaire de l'invention, le traitement de surface est retiré après l'étape de croissance des nano-fils.

L'invention concerne également un procédé de fabrication de composant optique comprenant une lentille solide à immersion et au moins un nano-fil couplé à la lentille solide à immersion. La formation du nano-fil sur la lentille solide à immersion est réalisée à l'aide du procédé de formation de nano-fil de l'invention.

Le composant optique obtenu par le procédé de fabrication de l'invention peut, par exemple, être incorporé dans un dispositif de détection en champ proche destiné à irradier, avec un rayonnement, un objet et à collecter le rayonnement réfléchi par cet objet. Le composant optique obtenu par le procédé de l'invention peut être, par exemple, une tête de lecture ou une tête de lecture et d'écriture d'informations optiques sur un support d'informations optiques, ou encore une sonde de microscope optique en champ proche.

Le procédé de formation de nano-fil de l'invention utilise un piège optique pour amener et déposer des particules métalliques (généralement des nano-billes) à la surface d'un substrat semi-conducteur fixé sur une lentille solide à immersion. Les particules métalliques sont ensuite utilisées comme catalyseurs pour la croissance de nano-fils par les méthodes connues telles que, par exemple, la méthode VLS. Les particules métalliques, et en conséquence les nano-fils, sont avantageusement localisés avec une précision de l'ordre de la dizaine de nanomètres. De façon avantageuse, pour la réalisation d'un composant optique muni d'une lentille solide à immersion couplée à un nano-fil, la lentille solide à immersion qui fait partie du composant optique participe à la formation du nano-fil. Le problème du centrage du nano-fil s'en trouve considérablement amélioré.

Le piège optique est réalisé à l'aide d'un dispositif à optique réfractive qui crée, à partir d'un faisceau lumineux, un faisceau lumineux fortement concentré. Le faisceau lumineux peut être, par exemple, un faisceau laser. Une particule située au voisinage du faisceau lumineux fortement concentré est soumise à des forces dites "forces de gradient" qui attirent la particule vers le maximum d'intensité du faisceau lumineux, lequel maximum se trouve dans la zone du faisceau la plus confinée. Les diamètres des particules piégées vont de la dizaine de microns à la dizaine de nanomètres. De façon générale, les particules qu'il est possible de déplacer à l'aide d'une pince optique sont de natures très différentes, à savoir des particules diélectriques, métalliques, semi-conductrices, biologiques, polymériques, etc.. Dans le cadre de l'invention, les particules sont des particules métalliques.

Les particules sont généralement mises en solution dans de l'eau désionisée mais il est également possible d'utiliser d'autres solvants comme, par exemple, l'éthanol. Le solvant doit avoir un indice de réfraction inférieur à celui de la particule, une viscosité voisine de celle de l'eau et il ne doit pas modifier l'état de surface de la particule.

Le faisceau lumineux est préférentiellement un faisceau laser. Le choix de la longueur d'onde du laser utilisé pour former la pince optique dépend de la nature des particules à piéger. En effet, les particules placées dans le flux laser subissent deux types de forces optiques: les forces de gradient qui sont attractives et amènent les particules vers la zone la plus concentrée faisceau laser et les forces d'absorption et de diffusion qui sont répulsives et qui poussent les particules dans la direction de propagation du faisceau laser, ce qui tend à déséquilibrer la pince. Pour que le piégeage soit possible, il faut que les forces de gradient soient très supérieures aux forces d'absorption et de diffusion. Ainsi, la longueur d'onde du laser doit-elle correspondre à un minimum d'absorption et de diffusion par la particule. Pour des particules d'or, on évite d'utiliser un laser à 532nm puisque cette longueur d'onde correspond à un maximum de diffusion par l'or.

Selon le mode de réalisation préférentiel de l'invention, les particules métalliques utilisées sont des particules d'or de diamètre allant typiquement de la dizaine de nanomètres à environ 250nm ou des particules d'argent de diamètre allant typiquement d'environ 20nm à 275nm.

En l'état actuel de la technique de piégeage de particules, des particules de plus grand diamètre ne peuvent pas être piégées avec un piège optique à faisceau gaussien unique. Une alternative est alors d'utiliser deux faisceaux laser contra-propagatifs, c'est-à-dire dont les sens de propagation sont opposés, focalisés au même point. On peut aussi travailler avec un seul faisceau mais dont la partie centrale est obscurcie. Dans ce dernier cas, les particules sont piégées par répulsion à l'aide d'un tore de lumière.

### Brève description des figures

D'autres caractéristiques et avantages de l'invention apparaîtront à la lecture de modes de réalisation préférentiels décrits en référence aux figures jointes, parmi lesquelles :
- Les figures 1A-1F représentent des étapes successives d'un exemple de procédé de croissance localisée de nano-fils sur un substrat;
- La figure 2 représente un exemple de dispositif qui met en oeuvre le procédé de croissance localisée de nano-fils décrit aux figures 1A-1F;
- Les figures 3A-3B représentent deux étapes d'une variante du procédé de croissance localisée de nano-fils représenté aux figures 1A-1F;
- La figure 4 représente un premier exemple de dispositif qui met en oeuvre le procédé de croissance localisée de nano-fils décrit aux figures 1A-1F;
- La figure 5 représente un deuxième exemple dedispositif qui met en oeuvre le procédé de croissance localisée de nano-fils décrit aux figures 1A-1F;
- Les figures 6A-6C représentent un exemple de procédé de croissance localisée de nano-fil sur une lentille solide à immersion conforme à l'invention;
- La figure 7 représente, à titre d'exemple, une étape particulière du procédé de croissance localisée de nano-fil sur une lentille solide à immersion conforme à l'invention.

Sur toutes les figures, les mêmes références désignent les mêmes éléments.

### Exposé détaillé de modes de réalisation particuliers de l'invention

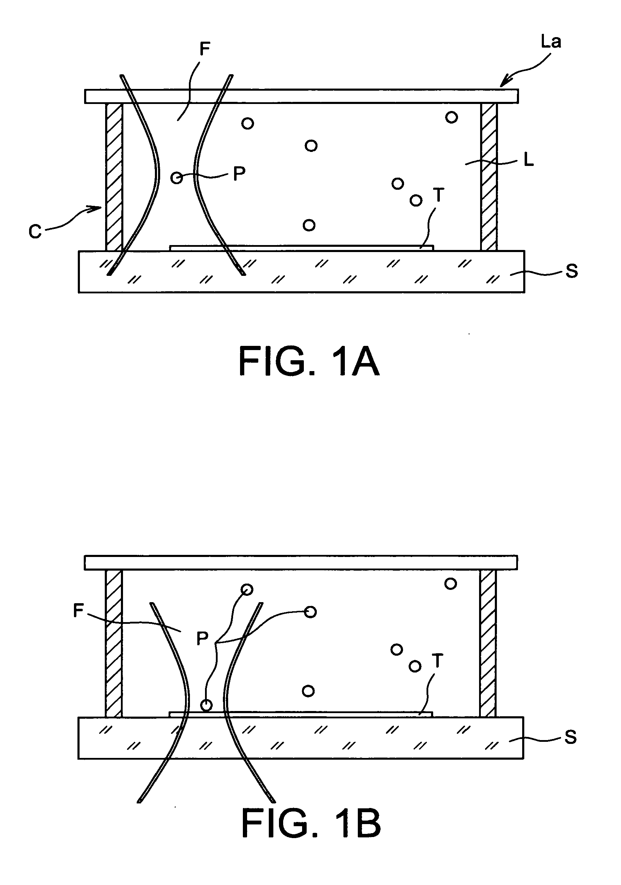

Les figures 1A-1F représentent des étapes successives d'un exemple de procédé de croissance localisée de nano-fils sur un substrat.

La pince optique est un waist de faisceau lumineux formé à l'aide d'un objectif de microscope dont l'ouverture numérique est supérieure à 1. Le faisceau lumineux à partir duquel est formé le waist est préférentiellement un faisceau laser.

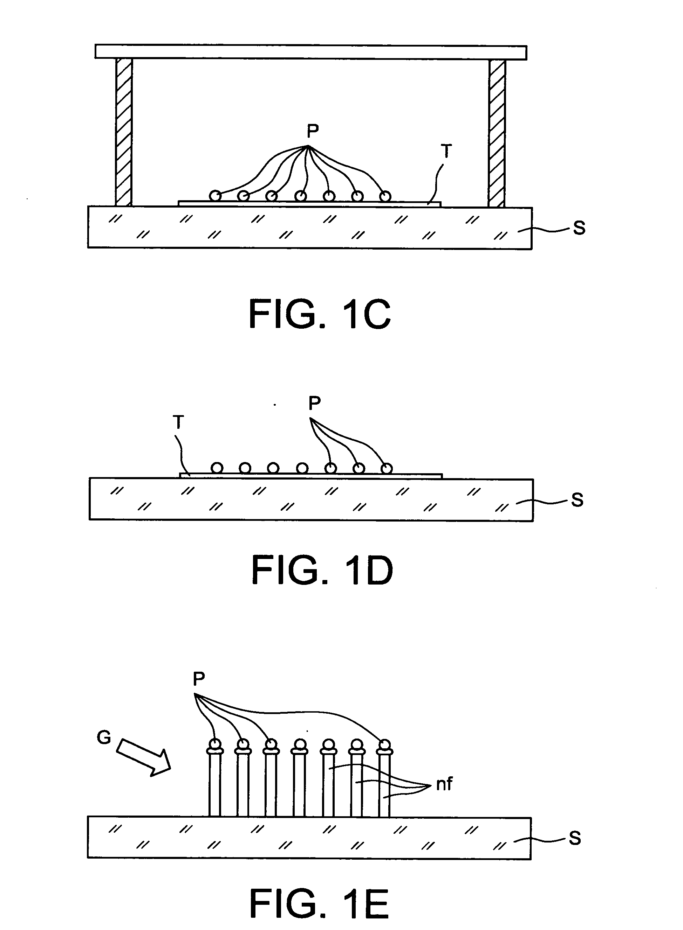

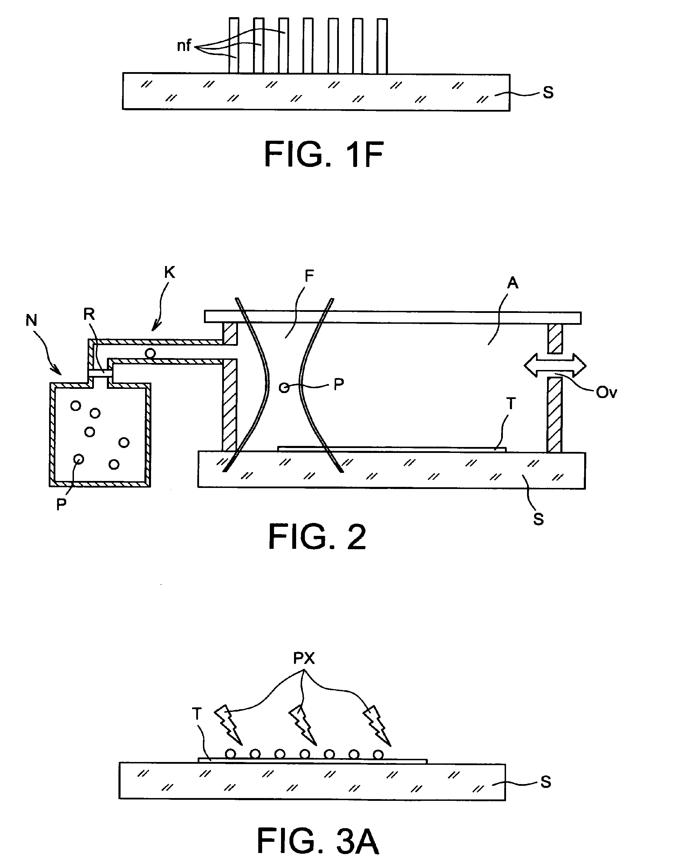

Des nanoparticules métalliques P sont placées dans une cuve C contenant un fluide, par exemple un liquide L. Le fonds de la cuve C est constitué par un substrat semi-conducteur S. Une lamelle couvre-objet La constitue, par exemple, un couvercle qui referme la cuve. De façon préférentielle, la face du substrat semi-conducteur destinée à être en contact avec le liquide L a été préalablement nettoyée par un procédé connu, par exemple un procédé du type traitement par plasma oxygène. De façon préférentielle également, un traitement de surface T, par exemple un traitement à la poly-L-lysine ou un traitement par aminosilane, recouvre la face du substrat semi-conducteur qui est au contact du liquide afin de faciliter la fixation des particules. La pince optique est réalisée par le waist W d'un faisceau lumineux F fortement concentré. La pince optique permet de déplacer, une par une, les nano-particules jusqu'à la surface du substrat (cf. figure 1B). Lorsqu'une nano-particule se pose sur le substrat, elle se fixe sur celui-ci du fait des forces électrostatiques présentes en surface du substrat (forces de Van der Walls). La présence éventuelle du traitement de surface T facilite cette fixation. Les nano-particules restent alors fixées sur le substrat même en l'absence de faisceau lumineux. L'étape de déplacement de nano-particules est répétée autant de fois qu'il le faut afin de fixer, dans la configuration spatiale souhaitée, la quantité de particules voulue (cf. figure 1C). La cuve C est ensuite retirée et les résidus de liquide L sont évaporés, par séchage, en contrôlant les conditions de température et de pression (cf. figure 1D). A titre d'exemple non limitatif, la température de séchage peut ainsi être égale à 35°C et la pression égale à 1 atm. Le substrat semi-conducteur S est ensuite placé dans un bâti de croissance (non représenté sur les figures) et des gaz précurseurs G sont introduits dans le bâti afin de déclencher un processus, connu en soi, de croissance des nano-fils. Les gaz précurseurs sont, par exemple, le protoxyde d'azote N₂O, ou le Diethylzinc pour les nanofils en oxyde de zinc (ZₙO) et le Silane SiH₄ pour les nanofils en silicium (Si). Une fois la croissance des nano-fils nf terminée (cf. figure 1E), les nano-particules métalliques P et le traitement de surface T, lorsqu'il existe, sont retirés, par exemple par attaque chimique (cf. figure 1F).

Par rapport aux techniques connues de localisation de nano-fils, le procédé présente les avantages suivants:
- Le procédé ne comprend aucune étape technologique coûteuse comme, par exemple, la lithographie ;
- Les nano-particules métalliques peuvent être placées à n'importe quel endroit de la surface du substrat et selon n'importe quel motif ;
- La précision avec laquelle sont localisées les nano-particules est de l'ordre de la dizaine de nanomètres ;
- La technique de l'invention est rapide, par exemple plus rapide que la technique AFM mentionnée précédemment.

Dans le cadre de l'invention, le traitement de surface T mentionné ci-dessus désigne une monocouche de molécules organiques d'une épaisseur de quelques nanomètres. Le choix des molécules organiques est adapté en fonction de la nature des nano-objets à créer et de la nature du substrat S. A titre d'exemple non limitatif, comme cela a été mentionné précédemment, le traitement de surface est un traitement à la poly-L-lysine.

La figure 2 représente un exemple de dispositif qui met en oeuvre le procédé de croissance de nano-fils illustré aux figures 1A-1F.

Selon cet exemple, le fluide qui emplit la cuve C n'est pas un liquide mais de l'air A. Avantageusement, il n'est alors pas nécessaire d'avoir à sécher, ultérieurement, le substrat S. Les nano-particules métalliques P sont mises en suspension dans l'air qui emplit la cuve C à l'aide d'un aérosol. Pour créer l'aérosol, on utilise, par exemple, un nébuliseur N muni d'un réseau R de trous agité par ultrasons. Les nano-particules P sont mises en suspension dans un solvant, par exemple l'éthanol, qui emplit le réservoir du nébuliseur. Les nano-particules P ont un diamètre inférieur à la taille des trous afin de pouvoir traverser le réseau. Une ouverture sur l'extérieur Ov est pratiquée dans la cuve C. L'ouverture Ov permet une évaporation rapide du solvant avant qu'une nano-particule P qui est entrée dans la cuve n'arrive dans le waist W du faisceau F. Les nano-particules sont ainsi piégées dans l'air. Une fois les nano-particules P déposées sur le substrat S, le procédé de croissance de nano-fils est conforme au procédé décrit précédemment, à l'exception de l'étape de séchage du substrat qui est ici avantageusement inutile, comme cela a été mentionné précédemment.

Les figures 3A-3B représentent deux étapes d'une variante du procédé illustré aux figures 1A-1F.

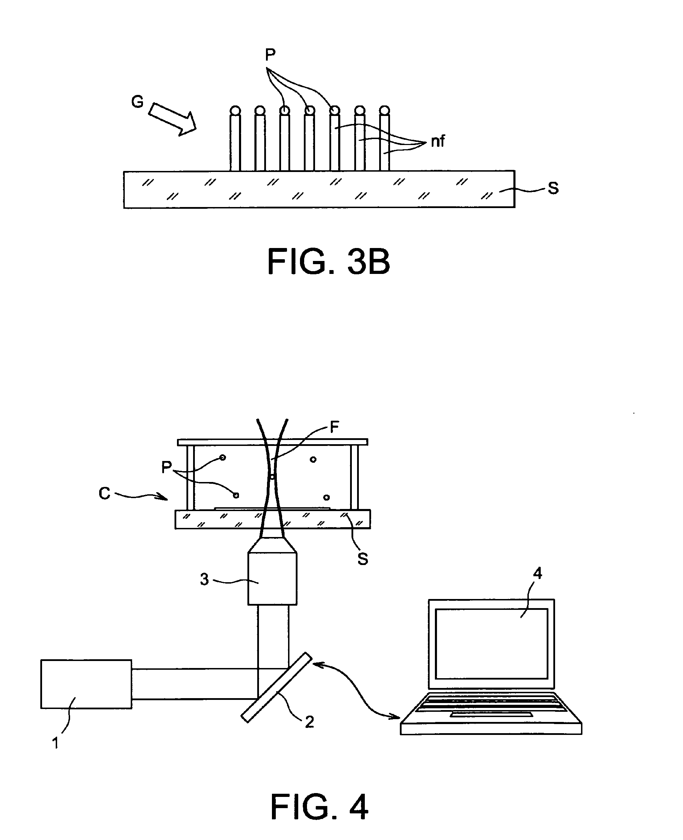

Selon cette variante, la couche de traitement de surface T est retirée avant la croissance des nano-fils, par exemple avec un traitement sous plasma oxygène PX. La couche de traitement de surface T est, de fait, une couche potentiellement contaminante entre le substrat S et les nano-particules métalliques P. Le retrait de la couche de traitement T évite ainsi toute contamination et permet, par ailleurs, une croissance plus homogène des nano-fils. Il est ainsi possible d'obtenir des nano-fils dont la verticalité par rapport au substrat est très sensiblement améliorée par rapport à une situation où la couche T est conservée pendant la croissance des nano-fils (cf. figure 3B).

La figure 4 représente un premier exemple de dispositif qui met en oeuvre un procédé de croissance localisée de nano-fils..

Selon cette variante, plusieurs faisceaux lumineux sont utilisés simultanément pour créer une pince optique multi-faisceaux. La pince optique multi-faisceaux est créée, de façon connue en soi, en intercalant un composant optique 2 entre le faisceau lumineux unique délivré par une source optique 1 et la cuve C. Le composant optique 2 est, par exemple, un composant diffractif, un composant holographique ou un composant constitué de un ou plusieurs modulateurs spatiaux de lumière. On génère ainsi plusieurs faisceaux lumineux, par exemple jusqu'à deux cents faisceaux, qui sont focalisés par une même lentille 3 dans la cuve C. Une pluralité de waists de faisceaux lumineux sont alors formés dans la cuve C. Le composant optique 2 est pilotable, par exemple par un ordinateur 4.

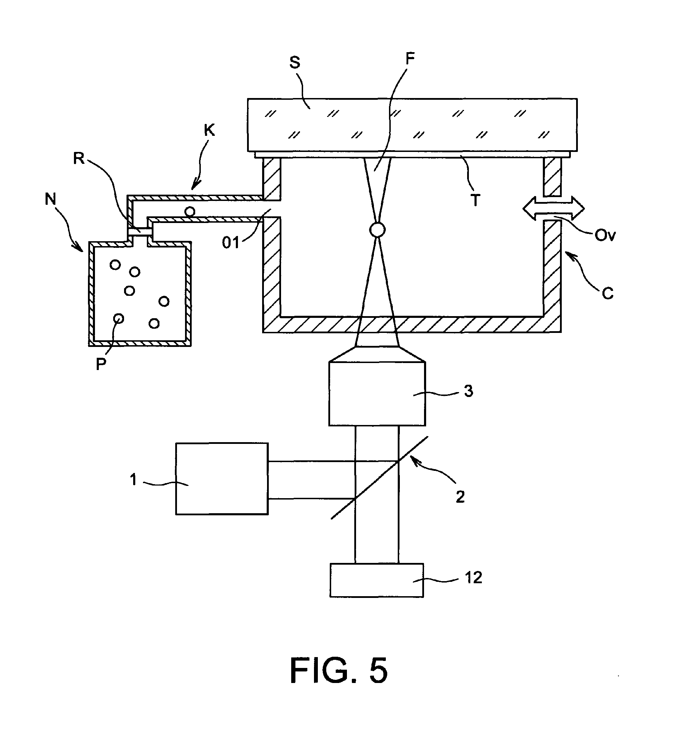

La figure 5 illustre un deuxième exemple de dispositif qui met en oeuvre un procédé de croissance localisée de nano-fils.

Des colloïdes d'or P de diamètre 50 nm sont mis en solution dans de l'éthanol. La solution de colloïdes est placée dans le réservoir d'un nébuliseur N qui permet de diffuser les particules métalliques sous forme d'aérosol. Une couche mince T de poly-L-lysine est déposée à la surface d'un wafer de silicium monocristallin S, pour faciliter une bonne accroche des colloïdes sur la surface. Les parois de la cuve C en PDMS (Polydiméthylsiloxane) sont fixées sur la face du wafer recouverte de la couche mince T. La cuve est transparente à la longueur d'onde du laser utilisé pour réaliser la pince optique. La cuve présente une première ouverture 01 sur un côté, dans laquelle est insérée l'extrémité du canal fluidique K. Le canal fluidique K relie la cuve au nébuliseur. La cuve présente également une seconde ouverture 0v qui établit une communication entre l'air présent à l'intérieur de la cuve et l'air extérieur. L'ensemble "cuve + substrat" est placé sur le porte-échantillon d'un microscope inversé. Le microscope comporte un objectif à immersion 3 ayant une ouverture numérique de 1,25. Cet objectif est utilisé à la fois pour la réalisation de la pince optique et pour l'observation de l'échantillon. Une caméra CCD 11 est placée derrière l'objectif de microscope pour la visualisation de l'échantillon. La pince optique est réalisée en injectant dans l'objectif 3 la lumière issue d'un laser YAG 1 émettant, à la longueur d'onde de 1064nm, une puissance de 100 mW. La pince optique est tout d'abord positionnée, à l'intérieur de la cuve, au niveau de la sortie du canal fluidique, pour attendre l'arrivée d'une particule en provenance du canal. Lorsqu'une particule est piégée, l'opérateur (ou un logiciel) déplace la pince optique et/ou la cuve de façon à placer la particule à la position désirée en surface du wafer. Une fois le laser 1 éteint, la particule reste fixée à la surface, grâce à la poly-L-lysine. Le processus est répété autant de fois qu'il est nécessaire. La cuve en PDMS est alors décollée de l'échantillon. Le substrat est nettoyé sous plasma d'oxygène, puis placé dans la chambre d'un bâti LPCVD (LPCVD pour « Low Pressure Chemical Vapor Deposition » / dépôt chimique en phase vapeur sous pression réduite). La croissance des nano-fils a lieu par méthode VLS (Vapor-Liquid-Solid), en introduisant du silane (SiH₄) dans le bâti, à un débit compris entre 10 et 30 sccm et avec une température de croissance comprise entre 400 et 650 °C.

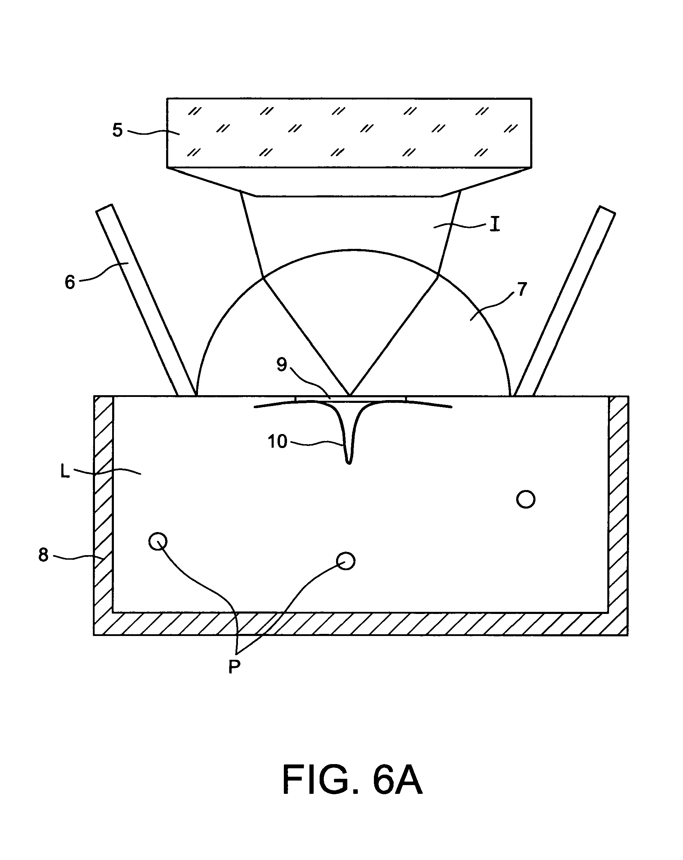

Les figures 6A-6C représentent des étapes d'un exemple de procédé de croissance localisée de nano-fil selon l'invention. Selon l'invention, une pince optique est réalisée à l'aide d'un faisceau lumineux fortement focalisé par une lentille solide à immersion.

Une lentille solide à immersion est une lentille, préférentiellement de forme hémisphérique, qui est fabriquée dans un matériau ayant un indice de réfraction n élevé ( 2 ≤ n ). L'utilisation d'une telle lentille permet d'augmenter l'ouverture numérique du système optique et, ainsi, de réduire la taille du point de focalisation d'un facteur 1/n par rapport à la limite de résolution dans l'air.

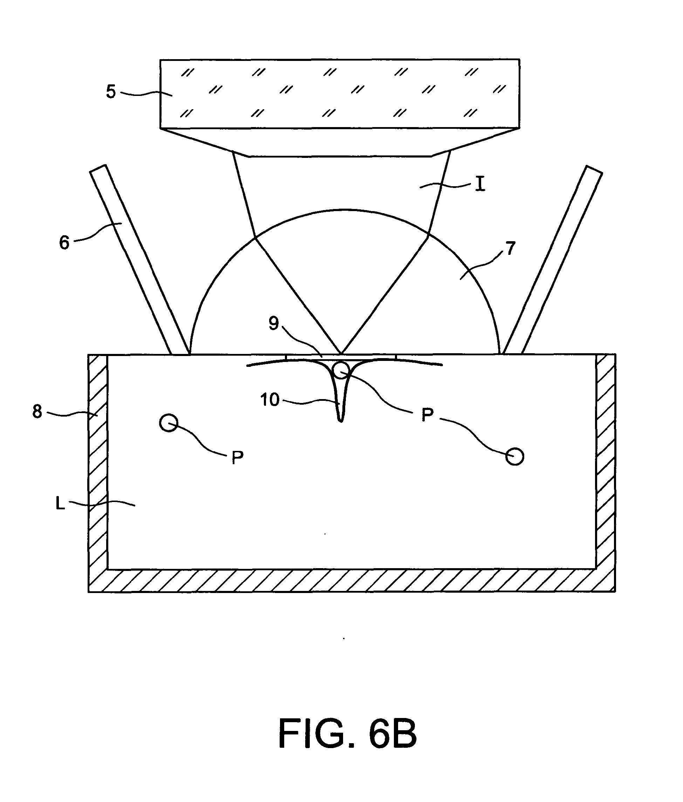

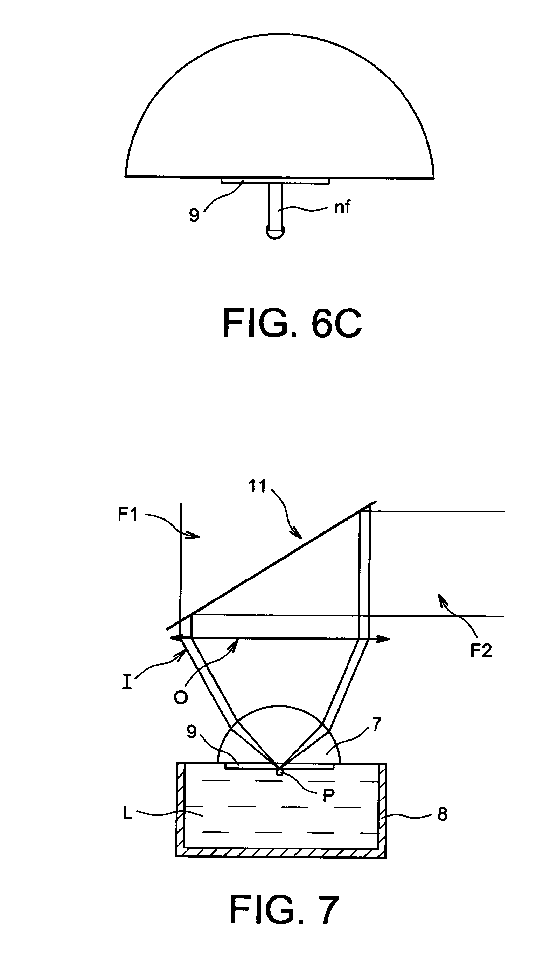

Le dispositif qui met en oeuvre le procédé de l'invention comprend ainsi une lentille solide à immersion 7 sur la face plane de laquelle est déposée une couche d'un matériau semi-conducteur 9. La couche de matériau semi-conducteur 9 est transparente à la longueur d'onde d'utilisation et a une épaisseur faible par rapport à cette longueur d'onde. L'ensemble lentille/couche de matériau semi-conducteur est partiellement placé dans une cuve 8 remplie d'un liquide L qui contient les particules métalliques P. La face plane de la lentille 7 recouverte de la couche semi-conductrice 9 est mise en contact avec le liquide, le reste de la lentille étant situé à l'extérieur de la cuve. La face de la couche de matériau semi-conducteur au contact du liquide L peut être recouverte du même traitement de surface T (poly-L-lysine) que celui décrit précédemment. La lentille est éclairée, du côté hémisphérique, à l'aide d'un faisceau lumineux focalisé I issu d'un objectif 5 de microscope à faible ouverture numérique. Un support 6 permet de maintenir la lentille 7 au contact du liquidé L. La cuve 8 est déplacée jusqu'à temps qu'une particule P soit positionnée à proximité du centre de la lentille 7. La lumière focalisée au niveau de l'ensemble lentille/couche de matériau semi-conducteur sert ici de pince optique pour piéger la particule de la même manière que le waist de faisceau laser de pince optique mentionné précédemment. Une fois la particule P au contact de la couche 9, la particule P se fixe sur la couche 9 par force électrostatique. Cette fixation par force électrostatique dépend de l'état de surface de la particule et de l'état de surface du substrat. Sur les figures 6A et 6B, la référence 10 représente, de façon symbolique, l'intensité lumineuse au foyer de la lentille 7.Une étape de croissance de nano-fil nf succède alors à la fixation de la particule P sur le substrat (cf. figure 6C).

La figure 7 représente, à titre d'exemple, une étape particulière d'une variante du procédé de croissance localisée de nano-fil de l'invention.

Selon cette étape particulière, les nano-particules métalliques sont fixées par fusion à la surface de la couche de matériau semi-conducteur 9. En plus du faisceau lumineux F1 qui crée la pince optique, un faisceau laser F2, par exemple un faisceau laser de type Ultra Violet (UV) impulsionnel, est également focalisé sur la couche de matériau semi-conducteur 9. Les faisceaux F1 et F2 sont alors injectés, via une lame semi-réfléchissante 11, dans un même objectif Ob de microscope à forte ouverture numérique. Une nano-particule métallique P qui est amenée et déposée sur la couche de matériau semi-conducteur 9 grâce à la pince optique est alors soudée sur cette même couche à l'aide du faisceau laser UV impulsionnel focalisé.

Selon le mode de réalisation préférentiel de l'invention décrit en référence aux figures 6A-6B et 7, une seule nano-particule P est fixée sur la couche 9. L'invention concerne cependant d'autres modes de réalisation dans lequels ce sont plusieurs nano-particules qui sont fixées sur la couche 9. Plusieurs nano-particules sont alors piégées dans le même faisceau focalisé.

Pour des raisons de commodité, dans la description ci-dessus, le terme « nano-particule » est utilisé pour désigner, de façon générale, toute particule de petites dimensions susceptible d'être positionné, en tant que catalyseur, sur le substrat. Le terme « nano-particule » ne doit bien sûr pas s'entendre comme un objet dont les dimensions sont exclusivement de l'ordre de quelques nanomètres. Les dimensions des « nano-particules » peuvent ainsi être comprises entre quelques nanomètres et quelques dizaines de micromètres.

## Revendications

1. Procédé de formation de nano-fil (nf) à la surface d'un substrat (S) fixé sur une face plane d'une lentille solide à immersion, le procédé comprenant une étape de formation d'au moins un élément catalyseur à la surface du substrat et une étape de croissance de nano-fil (nf) à partir de chaque élément catalyseur formé à la surface du substrat (S), **caractérisé en ce que**, l'élément catalyseur étant une nano-particule métallique (P) et le substrat étant transparent à une longueur d'onde de travail, l'étape de formation d'un élément catalyseur à la surface du substrat comprend les étapes successives suivantes :
- mise en contact du substrat avec un fluide (L) placé dans une cuve (8) qui contient des nano-particules métalliques,
- focalisation d'un faisceau lumineux à la longueur d'onde de travail au niveau du substrat, à l'aide d'un faisceau lumineux incident sur une face hémisphérique de la lentille solide à immersion,
- déplacement de la cuve jusqu'à temps qu'une nano-particule métallique soit piégée dans le faisceau lumineux focalisé, et
- fixation de la nano-particule piégée sur le substrat.

2. Procédé de formation de nano-fil selon la revendication 1, dans lequel, le fluide étant un liquide (L) qui emplit la cuve, dès lors qu'au moins une nano-particule métallique est fixée sur le substrat, la cuve est démontée et une étape de séchage sèche le substrat.

3. Procédé de formation de nano-fil selon la revendication 1, dans lequel le fluide étant de l'air (A) qui emplit la cuve, des nano-particules (P) sont introduites dans la cuve à l'aide d'un nébuliseur (N) et, dès lors qu'au moins une nano-particule est fixée sur le substrat, la cuve est démontée.

4. Procédé de formation de nano-fil selon l'une quelconque des revendications 1 à 3, dans lequel la nano-particule métallique est fixée par fusion à la surface du substrat.

5. Procédé de formation de nano-fil selon l'une quelconque des revendications précédentes, dans lequel le substrat est préalablement recouvert d'un traitement de surface (T) apte à faciliter la fixation de la nano-particule sur le substrat.

6. Procédé de formation de nano-fil selon la revendication 5, dans lequel le traitement de surface (T) est un traitement à la poly-L-lysine ou un traitement par aminosilane.

7. Procédé de formation de nano-fil selon l'une quelconque des revendications 5 ou 6, dans lequel, le traitement de surface est retiré avant l'étape de croissance du nano-fil.

8. Procédé de formation de nano-fil selon l'une quelconque des revendications 5 ou 6, dans lequel le traitement de surface est retiré après l'étape de croissance du nano-fil.

9. Procédé de fabrication d'un composant optique comprenant une lentille solide à immersion et au moins un nano-fil couplé à la lentille solide à immersion, le procédé comprenant une étape de formation du nanofil sur une face plane de la lentille solide à immersion, **caractérisé en ce que** l'étape de formation du nano-fil est réalisée à l'aide d'un procédé conforme à l'une quelconque des revendications 1 à 8.

## Claims

1. A method of formation of nanowires (nf) at the surface of a substrate (S) attached to a flat face of a solid immersion lens, where the method includes a step of formation of at least one catalyst element at the surface of the substrate, and a step of growth of nanowires (nf) from each catalyst element formed at the surface of the substrate (S), **characterised in that**, with the catalyst element being a metal nanoparticle (P) and with the substrate being transparent at the operating wavelength, the step of formation of a catalyst element at the surface of the substrate includes the following successive steps :
- bringing the substrate into contact with a fluid (L) placed in a tank (8) which contains metal nanoparticles,
- focusing of a light beam at the operating wavelength in the area of the substrate, using an incident light beam on a hemispherical face of the solid immersion lens,
- moving the tank until a metal nanoparticle is trapped in the focused light beam, and
- attaching the trapped nanoparticle on the substrate.

2. A method of formation of nanowires according to claim 1, in which, with the fluid being a liquid (L) which fills the tank, once the metal nanoparticle is attached to the substrate the tank is disassembled and the substrate is dried during a drying step.

3. A method of formation of nanowires according to claim 1, in which, with the fluid being air (A) which fills the tank, nanoparticles (P) are introduced into the tank using an atomiser (N) and, provided at least one nanoparticle is attached on the substrate, the tank is disassembled.

4. A method of formation of nanowires according to any of the claims 1 to 3, in which the metal nanoparticle is attached by fusion to the surface of the substrate.

5. A method of formation of nanowires according to any of the precious claims, in which the substrate is previously covered with a surface treatment (T) able to facilitate the attachment of the nanoparticle to the substrate.

6. A method of formation of nanowires according to claim 5, in which the surface treatment (T) is a treatment with poly-L-lysine or a treatment by aminosilane.

7. A method of formation of nanowires according to either of the claims 5 or 6, in which the surface treatment is removed before the step of growth of the nanowire.

8. A method of formation of nanowires according to either of the claims 5 or 6, in which the surface treatment is removed after the step of growth of the nanowire.

9. A method of manufacture of an optical component including a solid immersion lens and at least one nanowire coupled to the solid immersion lens, where the method includes a step of formation of the nanowire non a flat face of the solid immersion lens, **characterised in that** the step of formation of the nanowire is accomplished using a method in accordance with any of the claims 1 to 8.

## Patentansprüche

1. Verfahren zur Bildung von Nanodrähten (nf) auf der Oberfläche eines Substrats (S), das auf einer ebenen Fläche einer Festkörper-Immersionslinse befestigt ist, wobei das Verfahren eine Stafe der Bildung von mindestens einem Katalysatorelement auf der Oberfläche des Substrats und eine Stufe des Wachstums von Nanodrähten (nf) ausgehend von jedem auf der Oberfläche des Substrats (S) gebildeten Katalysatorelement umfasst, **dadurch gekennzeichnet, dass** das Katalysatorelement ein Metall-Nanoteilchen (P) ist und das Substrat bei einer Arbeitswellenlänge transparent ist, wobei die Stufe der Bildung eines Katalysatarelements auf der Oberfläche des Substrats die folgenden aufeinanderfolgenden Stufen umfasst:
- Inkontaktbringen des Substrats mit einem in eine Wanne (8) eingebrachten Fluid (L), das Metall-Nanoteilchen enthält,
- Fokussieren eines Lichtbündels mit der Arbeitswellenlänge auf der Ebene des Substrats mittels eines Lichtbündels, das auf eine Halbkugelfläche der Festkörper-Immersionslinse fällt,
- Verschieben der Wanne bis zu einem Zeitpunkt, an dem ein Metall-Nanoteilchen in dem fokussierten Lichtbündel eingefangen wird, und
- Befestigen des eingefangenen Nanoteilchens an dem Substrat.

2. Verfahren zur Bildung von Nanodrähten nach Anspruch 1, wobei das Fluid eine Flüssigkeit (L) ist, die die Wanne füllt, wobei, sobald mindestens ein Metall-Nanoteilchen an dem Substrat befestigt ist, die Wanne abmontiert wird und eine Trocknungsstufe das Substrat trocknet.

3. Verfahren zur Bildung von Nanodrähten nach Anspruch 1, wobei das Fluid Luft (A) ist, die die Wanne füllt, Nanoteilchen (P) in die Wanne mittels einer Vernebelungsvorrichtung (N) eingeführt werden und, sobald mindestens ein Nanoteilchen an dem Substrat befestigt ist, die Wanne abmontiert wird.

4. Verfahren zur Bildung von Nanodrähten nach einem der Ansprüche 1 bis 3, wobei das Metall-Nanoteilchen durch Fusion an der Oberfläche des Substrats befestigt wird.

5. Verfahren zur Bildung von Nanodrähten nach einem der vorhergehenden Ansprüche, wobei das Substrat im Voraus einer Oberflächenbehandlung (T) unterzogen wird, die geeignet ist, die Befestigung des Nanoteilchens an dem Substrat zu erleichtern.

6. Verfahren zur Bildung von Nanodrähten nach Anspruch 5, wobei die Oberflächenbehandlung (T) eine Behandlung mit PolyLysin oder eine Behandlung durch ein Aminosilan ist.

7. Verfahren zur Bildung von Nanodrähten nach einem der Ansprüche 5 oder 6, wobei die Oberflächenbehandlung vor der Stufe des Wachstums der Nanodrähte beendet wird.

8. Verfahren zur Bildung von Nanodrähten nach einem der Ansprüche 5 oder 6, wobei die Oberflächenbehandlung nach der Stufe des Wachstums der Nanodrähte beendet wird.

9. Verfahren zur Fertigung eines optischen Elements, das eine Festkörper-Immersionslinse und mindestens einen, an die Festkörper-Immersionslinse gekoppelten Nanofaden umfasst, wobei das Verfahren eine Stufe der Bildung des Nanofadens an einer ebenen Fläche der Festkörper-Immersionslinse umfasst, **dadurch gekennzeichnet, dass** die Stufe der Bildung des Nanofadens mittels eines Verfahrens gemäß einem der Ansprüche 1 bis 8 durchgeführt wird.
